(19) Europäisches Patentamt
European Patent Office
Office européen des brevets

(11) **EP 4 016 850 B1**

(12) **EUROPEAN PATENT SPECIFICATION**

(45) Date of publication and mention
of the grant of the patent:
**23.04.2025 Bulletin 2025/17**

(21) Application number: **20859424.2**

(22) Date of filing: **22.07.2020**

(51) International Patent Classification (IPC):
$H03M\ 13/13$ (2006.01)   $H03M\ 13/31$ (2006.01)
$H04L\ 1/00$ (2006.01)

(52) Cooperative Patent Classification (CPC):
**H03M 13/13; H03M 13/136; H03M 13/31;
H04L 1/0057**

(86) International application number:
**PCT/CN2020/103472**

(87) International publication number:
**WO 2021/036595 (04.03.2021 Gazette 2021/09)**

(54) **DATA ENCODING METHOD AND DEVICE**

DATENCODIERUNGSVERFAHREN UND VORRICHTUNG

PROCÉDÉ ET DISPOSITIF DE CODAGE DE DONNÉES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.08.2019 CN 201910810163**

(43) Date of publication of application:
**22.06.2022 Bulletin 2022/25**

(73) Proprietor: **Huawei Technologies Co., Ltd.
Longgang District
Shenzhen,
Guangdong 518129 (CN)**

(72) Inventors:
• **SHEN, Hui**
**Shenzhen, Guangdong 518129 (CN)**
• **LI, Bin**
**Shenzhen, Guangdong 518129 (CN)**
• **LIU, Ling**
**Shenzhen, Guangdong 518129 (CN)**
• **GU, Jiaqi**
**Shenzhen, Guangdong 518129 (CN)**

(74) Representative: **Thun, Clemens
Mitscherlich PartmbB
Patent- und Rechtsanwälte
Karlstraße 7
80333 München (DE)**

(56) References cited:
CN-A- 108 599 775    CN-A- 109 327 225
CN-A- 109 981 224    US-A1- 2019 097 756

• BERNHARD C GEIGER: "The Fractality of Polar
and Reed-Muller Codes", ARXIV.ORG, CORNELL
UNIVERSITY LIBRARY, 201 OLIN LIBRARY
CORNELL UNIVERSITY ITHACA, NY 14853, 17
June 2015 (2015-06-17), XP081348606, DOI:
10.3390/E20010070
• ERDAL ARIKAN: "PA survey of Reed-Muller
codes from Polar coding perspective", PROC.,
IEEE INFORMATION THEORY WORKSHOP, ITW
2010 IEEE, IEEE, PISCATAWAY, NJ, USA, 6
January 2010 (2010-01-06), pages 1 - 5,
XP031703947, ISBN: 978-1-4244-6372-5
• CHEN CHAOFAN ET AL: "Noncoherent Detection
With Polar Codes", IEEE ACCESS, vol. 7, 16
January 2019 (2019-01-16), pages 6362 - 6372,
XP011705596, DOI: 10.1109/
ACCESS.2018.2889498
• WEI R-Y: "Noncoherent Block-Coded MPSK",
IEEE TRANSACTIONS ON COMMUNICATIONS,
IEEE SERVICE CENTER, PISCATAWAY, NJ. USA,
vol. 53, no. 6, 1 June 2005 (2005-06-01), pages
978 - 986, XP011134641, ISSN: 0090-6778, DOI:
10.1109/TCOMM.2005.849989

EP 4 016 850 B1

## Description

### TECHNICAL FIELD

This application relates to the communications field, and in particular, to a data encoding method and a device.

### BACKGROUND

Currently, with development of the communications field, requirements on a delay, reliability, and the like of data transmission in various communication scenarios are increasingly high. As the most basic wireless access processing in data transmission, channel coding plays a quite important role in data transmission.

In an existing solution, a Reed-Muller (Reed-Muller, RM) code has a quite small coding distance, and therefore is widely applied in data transmission. A construction process of the RM code includes: calculating a weight of a row of a matrix F corresponding to each bit; using, as an information bit for carrying information that needs to be transmitted, a location corresponding to a sequence number of a row with a larger row weight in the RM code, and using, as a fixed bit that transmits no information and is usually set to 0, a location corresponding to a row with a smaller row weight in the RM code.

However, for an encoding manner such as an RM code or a polar code, if a receiving device uses binary phase shift keying (binary phase shift keying, BPSK) modulation, a decoding result may be inaccurate in an incoherent detection scenario because phase information needs to be used for BPSK modulation, causing a decoding error and degrading decoding performance.

The document BERNHARD C GEIGER: "The Fractality of Polar and Reed-Muller Codes", XP081348606 deals with generator matrices of polar codes and Reed-Muller codes.

The document ERDAL ARIKAN: "PA survey of Reed-Muller codes from Polar coding perspective", XP031703947 also deals with the generation of different encoding matrices.

The document CHEN CHAOFAN ET AL: "Noncoherent Detection With Polar Codes", XP011705596 deals with advanced decoding schemes for polar codes.

The document Ruey-Yi Wei: "Noncoherent Block-Coded MPSK", XP011134541, deals with obtaining good noncoherent block codes by properly choosing binary linear block codes as component codes for a block-coded modulation using MPSK.

### SUMMARY

The present invention is defined by the independent claims. Further advantageous developments are shown by the dependent claims.

This application provides a data encoding method and a device, to improve encoding/decoding in a case of incoherent detection and improve decoding accuracy.

In the embodiments of this application, after the column weights of the generator matrix are determined, the K sequence numbers are selected from sequence numbers of rows obtained by removing the sequence number of the column whose column weight is an odd number, and the locations of the information bits in the original bit sequence $u$ are determined based on the K sequence numbers. Therefore, column weights of columns in the generator matrix that correspond to the locations of the information bits in $u$ are even numbers. In an incoherent detection scenario, a decoding result on a receiving device side is not changed by a phase, so that a more accurate decoding result is obtained, thereby improving decoding performance.

### BRIEF DESCRIPTION OF DRAWINGS

FIG. 1A is a schematic diagram of a network architecture to which a data encoding method is applied according to this application;

FIG. 1B is another schematic diagram of a network architecture to which a data encoding method is applied according to this application;

FIG. 2 is a schematic flowchart of a data encoding method according to this application;

FIG. 3 is a schematic diagram of a BER change of a decoding result in an existing solution;

FIG. 4 is a schematic diagram of a BER change of a decoding result in a data encoding method according to this application;

FIG. 5 is another schematic diagram of a BER change of a decoding result in a data encoding method according to this application;

FIG. 6 is a schematic diagram depicting a structure of an encoding apparatus according to this application; and

FIG. 7 is another schematic diagram depicting a structure of an encoding apparatus according to this application.

## DESCRIPTION OF EMBODIMENTS

This application provides a data encoding method and a device, to improve encoding/decoding performance in a case of incoherent detection and improve decoding accuracy.

First, the data encoding method provided in this application may be applied to various communications systems or communications networks, for example, a 5G system, a long term evolution (long term evolution, LTE) system, a global system for mobile communications (global system for mobile communications, GSM) network, a code division multiple access (code division multiple access, CDMA) network, or a wideband code division multiple access (wideband code division multiple access, WCDMA) network, or another communications network or communications system that needs to perform data encoding, for example, worldwide interoperability for microwave access (worldwide interoperability for microwave access, WiMAX) or wireless fidelity (wireless fidelity, Wi-Fi).

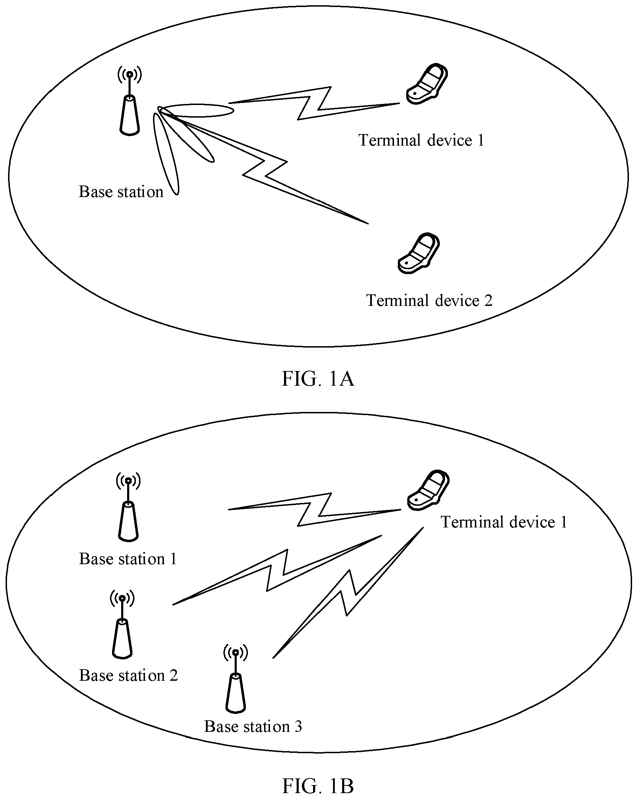

For example, a specific application scenario of the embodiments of this application may be shown in FIG. 1A or FIG. 1B. Specifically, the application scenario may include one or more base stations and one or more terminals. As shown in FIG. 1A, one base station may access a plurality of terminals (for example, a terminal 1 and a terminal 2 in FIG. 1A), in other words, one base station may communicate with a plurality of terminals. The base station may send encoded data to the plurality of terminals, or may receive encoded data sent by the terminal. As shown in FIG. 1B, one terminal may also communicate with a plurality of base stations (for example, a base station 1, a base station 2, and a base station 3 in FIG. 1B). The terminal may receive encoded data sent by the plurality base stations, or may send encoded data to the plurality of base stations.

Therefore, the encoding method provided in this application may be performed by an encoding apparatus. The encoding apparatus may include a base station, a terminal, or the like, or the encoding apparatus may be included in a device such as a base station or a terminal. The base station may be in various forms, such as a macro base station, a micro base station (also referred to as a small cell), a relay station, or an access point. The base station may have different names in different communications systems. For example, the base station may be a base transceiver station (base transceiver station, BTS) in a GSM or CDMA network, an NB (NodeB) in WCDMA, or an evolved NodeB (evolved NodeB, eNB or eNodeB) in an LTE system, or may be a base station device in a 5G network or a communications apparatus in a future evolved public land mobile network (public land mobile network, PLMN), for example, a next-generation NodeB (next-generation NodeB, gNB). The terminal may be any handheld device, wearable device, or computing device with a communication function, another processing device connected to a wireless modem, or the like. For example, the terminal may be a mobile station (mobile station, MS), a subscriber unit (subscriber unit), a cellular phone (cellular phone), a smartphone (smartphone), a wireless data card, a personal digital assistant (personal digital assistant, PDA) computer, a tablet computer, a wireless modem (modem), a handheld device (handheld device), a laptop computer (laptop computer), or a machine type communication (machine type communication, MTC) terminal.

The following describes in detail the encoding method provided in this application.

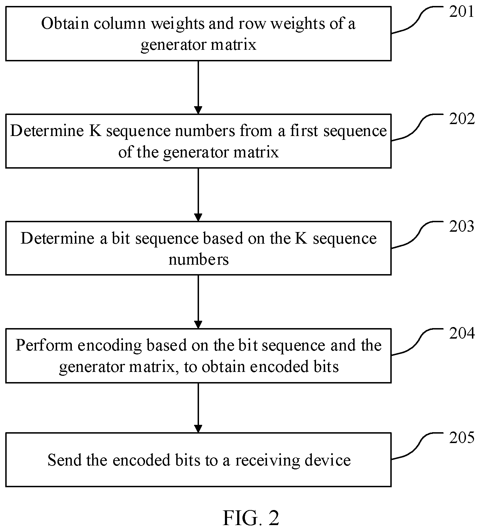

A specific procedure of the encoding method provided in this application may be shown in FIG. 2, as described below.

201. Obtain column weights and row weights of a generator matrix.

The generator matrix is a matrix corresponding to a code. The generator matrix may be a preset generator matrix, or may be a constructed generator matrix.

Specifically, the column weight of the generator matrix is to be understood as a quantity of 1s in a column, and the row weight of the generator matrix is to be understood as a quantity of 1s in a row.

$$G = \begin{bmatrix} 1 & 1 & 1 & 1 & 1 & 1 & 1 & 1 \\ 0 & 1 & 0 & 1 & 0 & 1 & 0 & 1 \\ 0 & 0 & 1 & 1 & 0 & 0 & 1 & 1 \\ 0 & 0 & 0 & 1 & 0 & 0 & 0 & 1 \\ 0 & 0 & 0 & 0 & 1 & 1 & 1 & 1 \\ 0 & 0 & 0 & 0 & 0 & 1 & 0 & 1 \\ 0 & 0 & 0 & 0 & 0 & 0 & 1 & 1 \\ 0 & 0 & 0 & 0 & 0 & 0 & 0 & 1 \end{bmatrix}$$

For example, the generator matrix G may be an $8 \times 8$ matrix, for example, .

Quantities of 1s in rows and quantities of 1s in columns in the matrix are separately calculated, and then column weights 1, 2, 2, 4, 2, 4, 4, and 8 and row weights 8, 4, 4, 2, 4, 2, 2, and 1 are obtained.

In an optional implementation, the generator matrix may be further constructed before step 201. Specifically, the generator matrix G is to be understood as an $n \times n$ matrix, and $G = F^{\otimes n}$. $F^{\otimes n}$ is a Kronecker (Kronecker) product of a matrix F raised to a power of n, and involved addition and multiplication operations are addition and multiplication operations in a binary Galois field (Galois field).

$$G = \begin{bmatrix} 1 & 1 & 1 & 1 & 1 & 1 & 1 & 1 \\ 0 & 1 & 0 & 1 & 0 & 1 & 0 & 1 \\ 0 & 0 & 1 & 1 & 0 & 0 & 1 & 1 \\ 0 & 0 & 0 & 1 & 0 & 0 & 0 & 1 \\ 0 & 0 & 0 & 0 & 1 & 1 & 1 & 1 \\ 0 & 0 & 0 & 0 & 0 & 1 & 0 & 1 \\ 0 & 0 & 0 & 0 & 0 & 0 & 1 & 1 \\ 0 & 0 & 0 & 0 & 0 & 0 & 0 & 1 \end{bmatrix}$$

For example, when $F = \begin{bmatrix} 1 & 1 \\ 0 & 1 \end{bmatrix}$ and n=8,

$$G = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

For another example, when $F = \begin{bmatrix} 1 & 0 \\ 1 & 1 \end{bmatrix}$ and n=8, .

In addition to a 2×2 matrix, *F* may be a 4×4 matrix, an 8×8 matrix, or the like. This may be specifically adjusted based on an actual application scenario, and this is not limited in this application.

202. Determine K sequence numbers from a first sequence of the generator matrix.

The first sequence is first determined. The first sequence includes numbers of rows of the generator matrix, and the first sequence does not include a sequence number of a column whose column weight is an odd number in the generator matrix.

Step 202 specifically includes: selecting the K sequence numbers in descending order of row weights of the rows corresponding to all the sequence numbers in the first sequence.

$$G = \begin{bmatrix} 1 & 1 & 1 & 1 & 1 & 1 & 1 & 1 \\ 0 & 1 & 0 & 1 & 0 & 1 & 0 & 1 \\ 0 & 0 & 1 & 1 & 0 & 0 & 1 & 1 \\ 0 & 0 & 0 & 1 & 0 & 0 & 0 & 1 \\ 0 & 0 & 0 & 0 & 1 & 1 & 1 & 1 \\ 0 & 0 & 0 & 0 & 0 & 1 & 0 & 1 \\ 0 & 0 & 0 & 0 & 0 & 0 & 1 & 1 \\ 0 & 0 & 0 & 0 & 0 & 0 & 0 & 1 \end{bmatrix}$$

For example, , where sequence numbers of columns are 0 to 7 from left to right, and sequence numbers of rows are 0 to 7 from top to bottom. Column weights are 1, 2, 2, 4, 2, 4, 4, and 8 from left to right, and row weights are 8, 4, 4, 2, 4, 2, 2, and 1 from top to bottom. In this case, the sequence number of the column whose column weight is an odd number in the generator matrix is 0. Therefore, the sequence number 0 is removed, and the sequence numbers included in the first sequence are 1 to 7. Then the K sequence numbers are selected from 1 to 7 based on row weights. If K is 3, the K sequence numbers include 1, 2, and 4 in descending order of row weights.

$$G = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

For another example, , where sequence numbers of columns are 0 to 7 from left to right, and sequence numbers of rows are 0 to 7 from top to bottom. Column weights are 8, 4, 4, 2, 4, 2, 2, and 1 from left to right, and row weights are 1, 2, 2, 4, 2, 4, 4, and 8 from top to bottom. In this case, the sequence number of the column whose column weight is an odd number in the generator matrix is 7. Therefore, the sequence number 7 is removed, and the sequence numbers included in the first sequence are 0 to 6. Then the K sequence numbers are selected from 0 to 6 based on row weights. If K is 3, the K sequence numbers include 3, 5, and 6 in descending order of row weights.

It should be noted that when there are a plurality of same row weights and there is no need to select all the same row weights, one or more of the same row weights may be randomly selected, or one or more of the row weights may be selected from top to bottom or from bottom to top. This is specifically adjusted based on an actual application scenario, and this is not limited in this application. For example, if K is 4, 5, or the like, after the sequence numbers 3, 5, and 6 are selected, one or two sequence numbers further need to be selected from 1, 2, and 4. In this case, one or two of the sequence numbers may be randomly selected, or one or two of the sequence numbers may be selected in ascending order or descending order.

203. Determine a bit sequence based on the K sequence numbers.

After the K sequence numbers are determined, the bit sequence $u$ is determined based on the K sequence numbers. The bit sequence includes an information bit and a fixed bit. The information bit is used to carry information, and the fixed bit does not transmit information, and is usually set to 0. The K sequence numbers are used to identify locations of the K information bits in $u$.

For example, if a length of the bit sequence $u$ is 8 bits, and the K sequence numbers include 3, 5, and 6, locations of corresponding information bits in the bit sequence $u$ are 0, 1, 2, 4, and 7.

204. Perform encoding based on the bit sequence and the generator matrix, to obtain encoded bits.

After the bit sequence $u$ is determined, encoding may be performed based on the bit sequence $u$ and the generator matrix, to obtain the encoded bits (which may also be referred to as encoded codewords).

Specifically, step 204 may include: performing Reed-Muller (RM) coding based on $u$ and the generator matrix, to obtain the encoded bits, where $c = uG$, $c$ is the encoded bits, and $G$ is the generator matrix. Certainly, another encoding manner similar to RM coding may alternatively be used.

More specifically, the K sequence numbers may be understood as being included in an index set A of information bits, and an index set of fixed bits is a complementary set $A^c$ of A. In this case, $c = uG = u_A G(A) \oplus u_{Ac} G(A^c)$.

$$G = \begin{bmatrix} 1 & 1 & 1 & 1 & 1 & 1 & 1 & 1 \\ 0 & 1 & 0 & 1 & 0 & 1 & 0 & 1 \\ 0 & 0 & 1 & 1 & 0 & 0 & 1 & 1 \\ 0 & 0 & 0 & 1 & 0 & 0 & 0 & 1 \\ 0 & 0 & 0 & 0 & 1 & 1 & 1 & 1 \\ 0 & 0 & 0 & 0 & 0 & 1 & 0 & 1 \\ 0 & 0 & 0 & 0 & 0 & 0 & 1 & 1 \\ 0 & 0 & 0 & 0 & 0 & 0 & 0 & 1 \end{bmatrix}$$

For another example, if , A includes [1, 2, 4, 5], and $A^c$ includes [0, 3, 6, 7],

$$c = uG = u_A G(A) \oplus u_{A^c} G(A^c) = (u_3, u_4, u_5, u_6) \begin{bmatrix} 0 & 1 & 0 & 1 & 0 & 1 & 0 & 1 \\ 0 & 0 & 1 & 1 & 0 & 0 & 0 & 0 \\ 0 & 0 & 0 & 0 & 1 & 1 & 1 & 1 \\ 0 & 0 & 0 & 0 & 0 & 1 & 0 & 1 \end{bmatrix} \oplus (0,0,0,0) G(A^c)$$

that is, the encoded bits $c$ may be obtained.

$$G = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

For another example, if , A includes [3, 4, 5, 6], and $A^c$ includes [0, 1, 2, 7],

$$c = uG = u_A G(\mathrm{A}) \oplus u_{A^c} G(\mathrm{A}^c) = (u_3, u_4, u_5, u_6) \begin{bmatrix} 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \end{bmatrix} \oplus (0,0,0,0) G(\mathrm{A}^c)$$

, that is, the encoded bits $c$ may be obtained.

Optionally, in an implementation, the bit sequence $u$ further includes a check bit, and the check bit is check data of the K information bits, or the check bit is check data of an even number of information bits in the K information bits. A checksum manner, parity check, or another check manner may be specifically used, to further improve accuracy of a decoding result.

When encoding is performed based on $u$ including a check bit, a specific encoding manner is similar to the foregoing encoding manner based on $u$ including no check bit. Details are not described herein again.

Generally, when the bit sequence $u$ includes a check bit, a quantity of included information bits may be less than a quantity of information bits included in the bit sequence $u$ when the bit sequence $u$ includes no check bit. For example, if the bit sequence $u$ includes on check bit, K may be 4; or if the bit sequence $u$ includes one check bit, K may be 3.

205. Send the encoded bits to a receiving device.

After the encoded bits are obtained, the encoded bits are sent to the receiving device.

Specifically, after the encoded bits are obtained, the encoded bits may be further modulated, and a modulated signal is sent to the receiving device wirelessly, wiredly, or in another manner.

In addition, other processing such as OFDM modulation may also be performed on the modulated signal. This is not limited in this application.

More specifically, after in the encoded bits is obtained, the modulated signal is obtained by using a modulation mapping function $map$ () . A modulated symbol included in the modulated signal is $map(c)$ . For example, the mapping function may map 0 or -1 to 0 and map 1 to 1, or map 1 to 0 and map 0 or -1 to 1.

A specific modulation scheme may be binary phase shift keying (binary phase shift keying, BPSK or 2PSK) modulation. Certainly, another modulation scheme may alternatively be used, and this is specifically adjusted based on an actual application scenario.

In addition, after step 206, the receiving device receives the modulated signal, and demodulates and decodes the

$$\hat{u} = \max_{u_i} | d_i * Z^H |$$

modulated signal. A specific decoding manner may include , where $\hat{u}$ is an information bit sequence obtained through decoding, $u_i$ is a possible information bit sequence, $d_i$ is a possible sent codeword, $Z$ is a received signal, and $H$ is a conjugate of the received signal.

Therefore, the receiving device may determine a decoding result by calculating an absolute value and a phase difference, so that an accurate decoding result can be obtained even if a case such as symbol flipping occurs. Compared with directly obtaining a decoding result by using phase information, this embodiment of this application can greatly improve accuracy of the obtained decoding result.

For example, some emulation diagrams of an RM code are used as examples to present examples of a decoding effect of encoded bits in the data encoding method provided in this application.

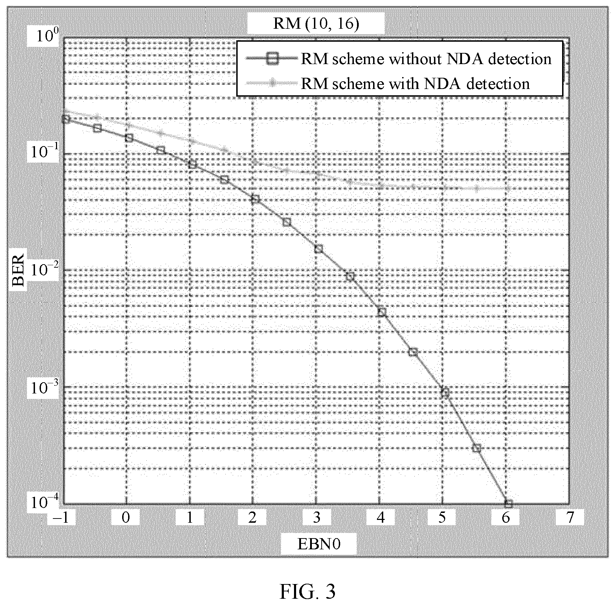

FIG. 3 is a schematic diagram of comparing bit error rates (bit error rates, BERs) of an RM code in an existing solution in coherent detection and incoherent detection scenarios when K=10 and N=16 (K may be understood as an information bit length and N may be understood as a code length) for an additive white Gaussian noise (additive white Gaussian noise, AWGN) channel. A vertical coordinate represents BER, a horizontal coordinate represents EbNo, which may also be represented by Eb/No, Eb represents energy per bit, and No represents power spectrum density. Clearly, incoherent detection and coherent detection differ greatly. In the incoherent detection scenario, an error floor appears at a high signal-to-noise ratio due to phase ambiguity.

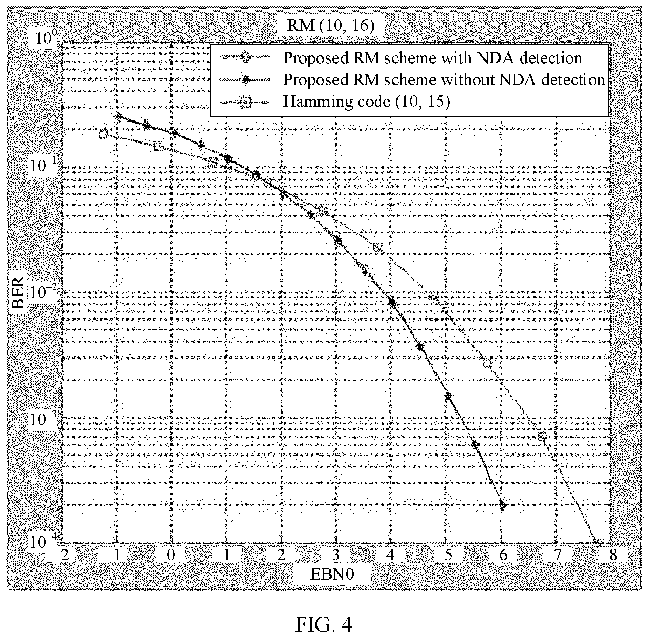

FIG. 4 is an emulation diagram of comparing decoding results of an RM code constructed in the method provided in this application in cases of coherent detection and incoherent detection when K=10 and N=16 (K may be understood as an information bit length and N may be understood as a code length) and a Hamming (Hamming) code in the coherent detection scenario when K=10 and N=15 for an AWGN channel. BERs of the RM code constructed in the method provided in this application in the two scenarios of coherent detection and incoherent detection are similar and are smaller than a BER of the Hamming code in the case of coherent detection.

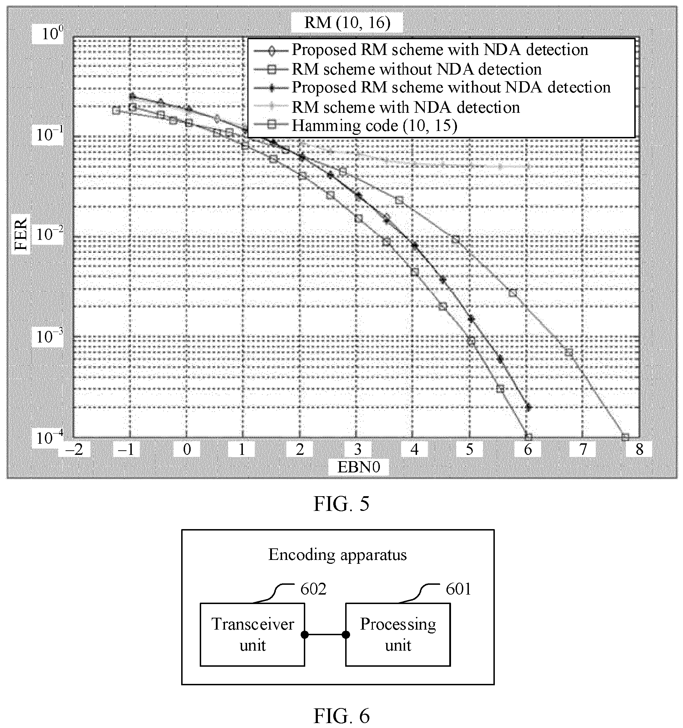

FIG. 5 is a diagram of comparing BER curves of an RM code constructed in the method provided in this application in coherent detection and incoherent detection scenarios when K=10 and N=16, a BER curve of a decoding result of a Hamming (Hamming) code in the coherent detection scenario when K=10 and N=15, and a BER curve of an RM code in an existing solution in the coherent detection and incoherent detection scenarios for an AWGN channel. Clearly, a BER of the RM code constructed in the method provided in this application is smaller than a BER of the RM code in the existing solution in the incoherent scenario, and a BER of the decoding result of the Hamming (Hamming) code in the coherent detection scenario is similar to a BER of the RM code in the existing solution in the coherent detection scenario.

Therefore, in the implementations of this application, after the column weights of the generator matrix are determined, the K sequence numbers are selected from sequence numbers of rows obtained by removing the sequence number of the column whose column weight is an odd number, and the locations of the information bits in the bit sequence $u$ are determined based on the K sequence numbers. Therefore, column weights of columns in the generator matrix that correspond to the locations of the information bits in $u$ are even numbers. When encoding is performed based on $u$ and the generator matrix, the encoded bits are modulated, and the modulated signal is sent to the receiving device, if BPSK modulation is used, the receiving device may also perform incoherent detection, and obtain an accurate decoding result based on a phase different between bits when phase information is inaccurate. For example, if a symbol of a bit is flipped, because a corresponding column weight is an even number, an accurate decoding result may be obtained based on a phase difference even if the symbol flipping occurs. Using a codeword constructed in the method provided in this application can greatly improve decoding performance.

For example, a procedure of constructing an RM code including no check bit is used as an example to describe this application in greater detail.

Example 1:

First, an RM code generator matrix is constructed, where $G=F^{\otimes n}$, and n may be understood as a code length. For

$$G=\begin{bmatrix} 1 & 1 & 1 & 1 & 1 & 1 & 1 & 1 \\ 0 & 1 & 0 & 1 & 0 & 1 & 0 & 1 \\ 0 & 0 & 1 & 1 & 0 & 0 & 0 & 0 \\ 0 & 0 & 0 & 1 & 0 & 0 & 0 & 0 \\ 0 & 0 & 0 & 0 & 1 & 1 & 1 & 1 \\ 0 & 0 & 0 & 0 & 0 & 1 & 0 & 1 \\ 0 & 0 & 0 & 0 & 0 & 0 & 1 & 1 \\ 0 & 0 & 0 & 0 & 0 & 0 & 0 & 1 \end{bmatrix}$$

example, when $F=\begin{bmatrix} 1 & 1 \\ 0 & 1 \end{bmatrix}$ and n=8, . Then a sequence number of a column whose column weight is an odd number in the matrix G is removed to obtain a first sequence, and then K rows are selected from the first sequence in descending order of row weights. Sequence numbers of the K rows correspond to locations of information bits in a bit sequence $u$. For example, K=4, In this case, indexes A of information bits includes [1, 2, 4, 5], and indexes $A^c$ of fixed bits includes [0, 3, 6, 7].

$$c = uG = u_A G(A) \oplus u_{A^c} G(A^c) = (u_3, u_4, u_5, u_6) \begin{bmatrix} 0 & 1 & 0 & 1 & 0 & 1 & 0 & 1 \\ 0 & 0 & 1 & 1 & 0 & 0 & 0 & 0 \\ 0 & 0 & 0 & 0 & 1 & 1 & 1 & 1 \\ 0 & 0 & 0 & 0 & 0 & 1 & 0 & 1 \end{bmatrix} \oplus (0,0,0,0) G(A^c)$$

.

Then the encoded bits $c$ are modulated to obtain a modulated signal $map(c)$, and the modulated signal is sent to a receiving device.

If the receiving device uses coherent detection, after passing through an additive white Gaussian noise (additive white Gaussian noise, AWGN) channel, a received signal is $y = map(c) + n$, where $n$ is noise. Then the receiving device decodes the received signal.

If the receiving device uses incoherent detection, a received signal is $Z = e^{j\theta} mapi(c) + n$. Then the receiving device performs decoding:

$$\hat{u} = \max_{u_i} |d_i * Z^H|$$

.

In addition, for an RM code constructed through fast Hadamard transformation (fast Hadamard transformation, FHT), the receiving device may alternatively use a similar decoding manner.

Therefore, in this example, maximization is implemented by using a decoding criterion, an RM code is decoded by using absolute values of a received signal and a transmitted codeword in a case of incoherent detection, so that decoding accuracy is greatly improved and decoding performance is improved.

Example 2:

First, a generator matrix is constructed, where $G=F^{\otimes n}$, and n may be understood as a code length. For example,

$$G=\begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

when $F=\begin{bmatrix} 1 & 0 \\ 1 & 1 \end{bmatrix}$ and n=8, .

Then a sequence number of a column whose column weight is an odd number in the matrix G is determined, and the sequence number is used as a sequence number of a check bit, namely, a sequence number 7. In addition, the sequence number of the column whose column weight is an odd number in the matrix G is removed to obtain a first sequence. Then K rows are selected from the first sequence in descending order of row weights. Sequence numbers of the K rows correspond to locations of information bits in a bit sequence $u$. For example, K=3.

In descending order of row weights, the K sequence numbers include A including [3, 5, 6], and A $^c$ includes [0, 1, 2, 4]. A (K, n) code may be obtained. The code is referred to as an RM-like code below.

A decoding manner of a receiving device is similar to that in Example 1. Details are not described herein again.

Therefore, in this example, maximization is implemented by using a decoding criterion, an RM code is decoded by using absolute values of a received signal and a transmitted codeword in a case of incoherent detection, so that decoding accuracy is greatly improved and decoding performance is improved. High-performance decoding can be performed even if a check bit is included.

The foregoing describes in detail the data encoding method provided in this application. With reference to the foregoing data encoding method, the following describes an encoding apparatus provided in this application. FIG. 6 is a schematic diagram depicting a structure of an encoding apparatus according to this application.

The encoding apparatus includes a processing unit 601 and a transceiver unit 602.

The processing unit 601 is configured to determine column weights and row weights of a generator matrix.

The processing unit 601 is further configured to determine K sequence numbers from a first sequence of the generator matrix, where the first sequence includes sequence numbers of rows of the generator matrix, and the first sequence does not include a sequence number of a column whose column weight is an odd number in the generator matrix.

The processing unit 601 is further configured to determine a bit sequence $u$ based on the K sequence numbers, where $u$ includes an information bit and a fixed bit, and the K sequence numbers are used to identify locations of K information bits in $u$.

The processing unit 601 is further configured to perform encoding based on $u$ and the generator matrix, where the K sequence numbers are the locations of the information bits in the bit sequence $u$, and the bit sequence $u$ includes the information bit and the fixed bit.

The transceiver unit 602 is configured to send the encoded bits to a receiving device.

Optionally, in some possible implementations, $u$ further includes a check bit.

The processing unit 601 is specifically configured to determine $u$ based on the K sequence numbers and the sequence number of the column whose column weight is an odd number in the generator matrix, where the sequence number of the column whose column weight is an odd number in the generator matrix is used to identify a location of the check bit in $u$, and the check bit is check data of the K information bits, or the check bit is check data of an even number of information bits in the K information bits.

Optionally, in some possible implementations, the processing unit 601 is specifically configured to perform Reed-Muller (RM) coding based on $u$ and the generator matrix, to obtain the encoded bits, where $c = uG$, $c$ is the encoded bits, and $G$ is the generator matrix.

Optionally, in some possible implementations, the processing unit 601 is specifically configured to: modulate the encoded bits, and send an obtained modulated signal to the receiving device, so that the receiving device demodulates and decodes the modulated signal through incoherent detection, to obtain information carried in the encoded bits.

Optionally, in some possible implementations, the processing unit 601 is specifically configured to determine the K sequence numbers in descending order of row weights of the rows corresponding to all the sequence numbers in the first sequence.

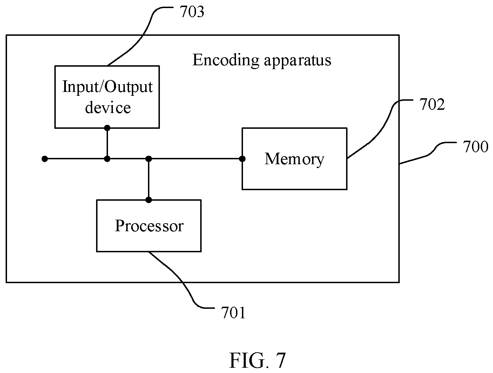

This application further provides an encoding apparatus 700. FIG. 7 shows an embodiment of a data encoding apparatus according to the embodiments of this application. The encoding apparatus may be configured to perform steps performed by the encoding apparatus in any one of the embodiments shown in FIG. 2 to FIG. 5. For details, refer to related descriptions in the foregoing method embodiments.

The encoding apparatus 700 includes a processor 701, a memory 702, and an input/output device 703.

In a possible implementation, the processor 701, the memory 702, and the input/output device 703 are separately connected to a bus, and the memory stores computer instructions.

The transceiver unit 601 in the foregoing embodiment may be the input/output device 703 in this embodiment. Therefore, an implementation of the input/output device 703 is not described again.

The processing unit 602 in the foregoing embodiment may be the processor 701 in this embodiment. Therefore, an implementation of the processor 701 is not described again.

In an implementation, the encoding apparatus 700 may include more or fewer components than those shown in FIG. 7. This is merely an example for description and does not constitute any limitation in this application.

This application provides a chip system. The chip system includes a processor, configured to support an encoding apparatus to implement functions in the foregoing aspects, for example, sending or processing data and/or information in the foregoing method. In a possible design, the chip system further includes a memory. The memory is configured to store necessary program instructions and data. The chip system may include a chip, or may include a chip and another discrete component.

In another possible design, when the chip system is a chip in the encoding apparatus, the chip includes a processing unit and a communications unit. The processing unit may be, for example, a processor. The communications unit may be, for example, an input/output interface, a pin, or a circuit. The processing unit may execute computer-executable instructions stored in a storage unit, so that the chip in the encoding apparatus performs the steps of the method performed by the encoding apparatus in any one of the embodiments in FIG. 2 to FIG. 5. Optionally, the storage unit is a storage unit in the chip, such as a register or a buffer, or the storage unit may be a storage unit in the encoding apparatus but outside the chip, such as a read-only memory (read-only memory, ROM), another type of static storage device capable of storing static information and instructions, or a random access memory (random access memory, RAM).

An embodiment of this application further provides a processor. The processor is coupled to a memory, and is configured to perform the method and the functions of the encoding apparatus in any one of the foregoing embodiments.

An embodiment of this application further provides a computer-readable storage medium that stores a computer program. When the computer program is executed by a computer, the computer program implements the method procedure related to the encoding apparatus in any one of the method embodiments. Correspondingly, the computer may be the foregoing encoding apparatus.

It should be understood that the processor in the encoding apparatus, the chip system, or the like in the foregoing embodiments of this application, or the processor provided in the foregoing embodiments of this application may be a central processing unit (central processing unit, CPU), or may be another general-purpose processor, a digital signal processor (digital signal processor, DSP), an application-specific integrated circuit (application-specific integrated circuit, ASIC), a field programmable gate array (field programmable gate array, FPGA) or another programmable logic device, a discrete gate or a transistor logic device, a discrete hardware component, or the like. The general-purpose processor may be a microprocessor, or the processor may be any conventional processor, or the like.

It should be further understood that there may be one or more processors in the encoding apparatus, the chip system, or the like in the foregoing embodiments of this application. The quantity may be adjusted based on an actual application scenario. This is merely an example for description herein, and is not limited. There may be one or more memories in the embodiments of this application. The quantity may be adjusted based on an actual application scenario. This is merely an example for description herein, and is not limited.

It should be further understood that in the embodiments of this application, the memory, the readable storage medium, or the like mentioned in the encoding apparatus, the chip system, or the like in the foregoing embodiments may be a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM) that is used as an external cache. Through examples but not limitative descriptions, many forms of RAMs may be used, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchronous link dynamic random access memory (synchlink DRAM, SLDRAM), and a direct rambus random access memory (direct rambus RAM, DR RAM).

It should be further noted that when the encoding apparatus includes a processor (or a processing unit) and a memory, the processor in this application may be integrated with the memory, or may be connected to the memory through an interface. This may be adjusted based on an actual application scenario, and is not limited.

An embodiment of this application further provides a computer program or a computer program product including the computer program. When the computer program is executed by a computer, the computer is enabled to implement a method procedure related to the encoding apparatus in any one of the foregoing method embodiments. Correspondingly, the computer may be the foregoing encoding apparatus.

All or some of the foregoing embodiments in FIG. 2 to FIG. 5 may be implemented by using software, hardware, firmware, or any combination thereof. When software is used to implement the embodiments, all or some of the foregoing embodiments may be implemented in a form of a computer program product.

The computer program product includes one or more computer instructions. When the computer instructions are loaded and executed on a computer, the procedure or functions according to the embodiments of this application are completely or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid-state disk (Solid-State Disk, SSD)), or the like.

It may be clearly understood by persons skilled in the art that, for the purpose of convenient and brief description, for a detailed working process of the foregoing system, apparatus, and unit, refer to a corresponding process in the foregoing method embodiments, and details are not described herein again.

In the several embodiments provided in this application, it should be understood that the disclosed system, apparatus, and method may be implemented in another manner. For example, the described apparatus embodiment is merely an example. For example, division into units is merely logical function division and may be other division in an actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of the embodiments.

In addition, functional units in the embodiments of this application may be integrated into one processing unit, or each of the units may exist alone physically, or two or more units may be integrated into one unit. The integrated unit may be implemented in a form of hardware, or may be implemented in a form of a software functional unit.

When the integrated unit is implemented in a form of a software functional unit and sold or used as an independent product, the integrated unit may be stored in a computer-readable storage medium. Based on such an understanding, the technical solutions of this application essentially, or the part contributing to the prior art, or all or some of the technical solutions may be implemented in the form of a software product. The computer software product is stored in a storage medium and includes several instructions for instructing a computer device (which may be a personal computer, an encoding apparatus, another network device, or the like) to perform all or some of the steps of the methods in the embodiments in FIG. 2 to FIG. 5 of this application. The storage medium includes various media that may store program code, such as a USB flash drive, a removable hard disk, a read-only memory (read-only memory, ROM), a random access memory (random access memory, RAM), a magnetic disk, or an optical disc.

In the specification, claims, and the accompanying drawings of this application, the terms "first", "second", and the like are intended to distinguish between similar objects but do not necessarily indicate a specific order or sequence. It should be understood that the terms used in such a way are interchangeable in proper cases. This is merely a discrimination manner that is used when objects having a same attribute are described in the embodiments of this application. In addition, the terms "include", "have", and any other variations thereof are intended to cover the non-exclusive inclusion, so that a process, method, system, product, or device that includes a series of units is not limited to those units, but may include other units not expressly listed or inherent to such a process, method, product, or device.

Names of messages/frames/information, modules, units, or the like provided in the embodiments of this application are merely examples, and other names may be used provided that the messages/frames/information, modules, units, or the like have same functions.

The terms used in the embodiments of this application are merely for the purpose of illustrating specific embodiments, and are not intended to limit the present invention. The terms "a", "the", and "this" of singular forms used in the embodiments of this application are also intended to include plural forms, unless otherwise specified. It should be further understood that in the descriptions of this application, "/" represents an "or" relationship between associated objects unless otherwise specified. For example, A/B may represent A or B. The term "and/or" in this application is merely an association relationship for describing associated objects, and represents that three relationships may exist. For example, A and/or B may represent the following three cases: Only A exists, both A and B exist, and only B exists, where A and B each may be singular or plural.

Depending on the context, for example, words "if" used herein may be explained as "while" or "when" or "in response to determining" or "in response to detection". Similarly, depending on the context, phrases "if determining" or "if detecting (a stated condition or event)" may be explained as "when determining" or "in response to determining" or "when detecting (the stated condition or event)" or "in response to detecting (the stated condition or event)".

In conclusion, the foregoing embodiments are merely intended to describe the technical solutions of this application, but not to limit the scope of the invention as defined by the claims.

**Claims**

1. A data encoding method performed by an encoding apparatus, the method comprising the steps of:

   • obtaining (step 201) column weigths and row weigths of a n $\times$ n generator matrix G being defined as $G = F^{\otimes n}$, wherein $F^{\otimes n}$ is a Kronecker product of a matrix F raised to the power of n, and F is one of:

   $$\begin{bmatrix} 1 & 0 \\ 1 & 1 \end{bmatrix}$$

   or

   $$\begin{bmatrix} 1 & 1 \\ 0 & 1 \end{bmatrix}$$

   • determining (step 202) K sequence numbers from a first sequence of the generator matrix G, wherein the first sequence comprises sequence numbers of rows of the generator matrix G, and the first sequence does not comprise a sequence number of a column whose column weight is an odd number in the generator matrix G, wherein the determining the K sequence numbers from the first sequence of the generator matrix G comprises:

       o determining the K sequence numbers in descending order of the obtained row weights of the rows corresponding to all the sequence numbers in the first sequence;

   • determining (203) a bit sequence $u$ based on the K sequence numbers, wherein $u$ comprises K information bits and a fixed bit, wherein the K sequence numbers are used to identify locations of the K information bits in $u$;
   • performing (204) encoding based on $u$ and the generator matrix G, to obtain encoded bits c = uG; and
   • sending the encoded bits to a receiving device.

2. **The method** according to claim 1, wherein $u$ further comprises a check bit, and the determining the bit sequence $u$ based on the K sequence numbers comprises:

   o determining $u$ based on the K sequence numbers and the sequence number of the column whose column weight is an odd number in the generator matrix, wherein the sequence number of the column whose column weight is an odd number in the generator matrix is used to identify a location of the check bit in $u$, and the check bit is check data of the K information bits, or the check bit is check data of an even number of information bits in the K information bits.

3. The method according to any one of claims 1 to 2, wherein the sending the encoded bits to the receiving device comprises:

∘ modulating the encoded bits, and sending (205) an obtained modulated signal to the receiving device, so that the receiving device demodulates and decodes the modulated signal through incoherent detection, to obtain information carried in the encoded bits.

4. An encoding apparatus configured to perform any of the methods according to claims 1 - 3.

5. A computer-readable storage medium comprising instructions, wherein, when the instructions are run on a computer of an encoding apparatus, the encoding apparatus is caused to perform the method according to any one of claims 1 to 3.

**Patentansprüche**

1. Datencodierungsverfahren, das durch ein Codierungsgerät durchgeführt wird, wobei das Verfahren die folgenden Schritte umfasst:

• Erlangen (Schritt 201) von Spaltengewichten und Zeilengewichten einer n × n Generatormatrix G, die als $G = F^{\otimes n}$ definiert ist, wobei $F^{\otimes n}$ ein Kronecker-Produkt einer Matrix F angehoben zur Potenz von n ist und F eines von Folgendem ist:

$$\begin{bmatrix} 1 & 0 \\ 1 & 1 \end{bmatrix}$$

oder

$$\begin{bmatrix} 1 & 1 \\ 0 & 1 \end{bmatrix}$$

• Bestimmen (Schritt 202) von K Sequenznummern aus einer ersten Sequenz der Generatormatrix G, wobei die erste Sequenz Sequenznummern von Zeilen der Generatormatrix G umfasst und die erste Sequenz keine Sequenznummer einer Spalte umfasst, deren Spaltengewicht eine ungerade Zahl in der Generatormatrix G ist, wobei das Bestimmen der K Sequenznummern aus der ersten Sequenz der Generatormatrix G Folgendes umfasst:

o Bestimmen der K Sequenznummern in absteigender Reihenfolge der erlangten Reihengewichte der Zeilen, die allen Sequenznummern der ersten Sequenz entsprechen;

• Bestimmen (203) einer Bitsequenz $u$ basierend auf den K Sequenznummern, wobei $u$ K Informationsbits und ein festes Bit umfasst, wobei die K Sequenznummern verwendet werden, um Standorte der K Informationsbits in $u$ zu identifizieren;
• Durchführen (204) von Codieren basierend auf $u$ und der Generatormatrix G, um codierte Bits c = uG zu erlangen; und
• Senden der codierten Bits an eine Empfangsvorrichtung.

2. Verfahren nach Anspruch 1, wobei $u$ ferner ein Prüfbit umfasst und das Bestimmen der Bitfolge $u$ basierend auf den K Sequenznummern Folgendes umfasst:

o Bestimmen von $u$ basierend auf den K Sequenznummern und der Sequenznummer der Spalte, deren Spaltengewicht eine ungerade Zahl in der Generatormatrix ist, wobei die Sequenznummer der Spalte, deren Spaltengewicht eine ungerade Zahl in der Generatormatrix ist, verwendet wird, um einen Standort des Prüfbits in $u$ zu identifizieren, und das Prüfbit Prüfdaten der K Informationsbits ist oder das Prüfbit Prüfdaten einer geraden Anzahl von Informationsbits in den K Informationsbits ist.

3. Verfahren nach einem der Ansprüche 1 bis 2, wobei das Senden der codierten Bits an die Empfangsvorrichtung Folgendes umfasst:

o Modulieren der codierten Bits und Senden (205) eines erlangten modulierten Signals an die Empfangsvorrichtung, sodass die Empfangsvorrichtung das modulierte Signal durch inkohärente Detektion demoduliert und decodiert, um die in den codierten Bits enthaltenen Informationen zu erlangen.

**4.** Codierungsgerät, das dazu konfiguriert ist, ein beliebiges der Verfahren nach den Ansprüchen 1-3 durchzuführen.

**5.** Computerlesbares Speichermedium, umfassend Anweisungen, wobei, wenn die Anweisungen auf einem Computer eines Codierungsgeräts ausgeführt werden, das Codierungsgerät veranlasst wird, das Verfahren nach einem der Ansprüche 1 bis 3 durchzuführen.

**Revendications**

**1.** Procédé de codage de données mis en œuvre par un appareil de codage, le procédé comprenant les étapes suivantes :

• l'obtention (étape 201) de poids de colonne et de poids de ligne d'une matrice génératrice G n× n étant définie comme $G = F^{\otimes n}$, dans lequel $F^{\otimes n}$ est un produit de Kronecker d'une matrice F élevée à la puissance n, et F est l'un des éléments suivants :

$$\begin{bmatrix} 1 & 0 \\ 1 & 1 \end{bmatrix}$$

ou

$$\begin{bmatrix} 1 & 1 \\ 0 & 1 \end{bmatrix}$$

• la détermination (étape 202) de K numéros de séquence à partir d'une première séquence de la matrice génératrice G, dans lequel la première séquence comprend des numéros de séquence de lignes de la matrice génératrice G, et la première séquence ne comprend pas de numéro de séquence d'une colonne dont le poids de colonne est un nombre impair dans la matrice génératrice G, dans lequel la détermination des K numéros de séquence à partir de la première séquence de la matrice génératrice G comprend :

o la détermination de K numéros de séquence dans l'ordre décroissant des poids de ligne obtenus des lignes correspondant à tous les numéros de séquence dans la première séquence ;

• la détermination (203) d'une séquence de bits $u$ sur la base des K numéros de séquence, dans lequel $u$ comprend K bits d'information et un bit fixe, dans lequel les K numéros de séquence sont utilisés pour identifier les emplacements des K bits d'information dans $u$ ;
• la mise en œuvre (204) d'un codage sur la base de $u$ et de la matrice génératrice G, pour obtenir des bits codés c = uG ; et
• l'envoi des bits codés à un appareil de réception.

**2.** Procédé selon la revendication 1, dans lequel $u$ comprend également un bit de contrôle, et la détermination de la séquence de bits $u$ sur la base des K numéros de séquence comprend :

o la détermination de $u$ sur la base des numéros de séquence K et du numéro de séquence de la colonne dont le poids de colonne est un nombre impair dans la matrice génératrice, dans lequel le numéro de séquence de la colonne dont le poids de colonne est un nombre impair dans la matrice génératrice est utilisé pour identifier un emplacement du bit de contrôle dans $u$, et le bit de contrôle est une donnée de contrôle des K bits d'information, ou le bit de contrôle est une donnée de contrôle d'un nombre pair de bits d'information dans les K bits d'information.

**3.** Procédé selon l'une quelconque des revendications 1 à 2, dans lequel l'envoi des bits codés au dispositif de réception comprend :

o la modulation des bits codés, et l'envoi (205) d'un signal modulé obtenu au dispositif de réception, de sorte que le dispositif de réception démodule et décode le signal modulé par détection incohérente, pour obtenir des informations transportées dans les bits codés.

4. Appareil de codage configuré pour réaliser l'un quelconque des procédés selon les revendications 1 à 3.

5. Support de stockage lisible par ordinateur comprenant des instructions, dans lequel, lorsque les instructions sont exécutées sur un appareil de codage, l'appareil de codage est amené à mettre en œuvre le procédé selon l'une quelconque des revendications 1 à 3.

Terminal device 1

Base station

Terminal device 2

FIG. 1A

Terminal device 1

Base station 1

Base station 2

Base station 3

FIG. 1B

```
┌─────────────────────────────────────┐
│  Obtain column weights and row       │ ⟋ 201
│  weights of a generator matrix       │
└─────────────────────────────────────┘
                  │
                  ▼
┌─────────────────────────────────────┐
│ Determine K sequence numbers from a  │ ⟋ 202
│ first sequence of the generator matrix│
└─────────────────────────────────────┘
                  │
                  ▼
┌─────────────────────────────────────┐
│  Determine a bit sequence based on   │ ⟋ 203
│  the K sequence numbers              │
└─────────────────────────────────────┘
                  │
                  ▼
┌─────────────────────────────────────┐
│ Perform encoding based on the bit    │ ⟋ 204
│ sequence and the generator matrix,   │
│ to obtain encoded bits               │
└─────────────────────────────────────┘
                  │
                  ▼
┌─────────────────────────────────────┐
│  Send the encoded bits to a          │ ⟋ 205
│  receiving device                    │
└─────────────────────────────────────┘
```

FIG. 2

FIG. 3

FIG. 4

FIG. 5

FIG. 6

703

Encoding apparatus

Input/Output
device

702

Memory

700

Processor

701

FIG. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **BERNHARD C GEIGER**. The Fractality of Polar and Reed-Muller Codes. *XP081348606*
- **ERDAL ARIKAN**. PA survey of Reed-Muller codes from Polar coding perspective. *XP031703947*
- **CHEN CHAOFAN et al.** Noncoherent Detection With Polar Codes. *XP011705596*
- **RUEY-YI WEI**. Noncoherent Block-Coded MPSK. *XP011134541*